# EUROPÄISCHE PATENTANMELDUNG

(11) **EP 0 948 042 A1**
(43) Veröffentlichungstag der Anmeldung: **06.10.1999**
(21) Anmeldenummer: 98104034.8
(22) Anmeldetag: 06.03.1998
(51) Int. Cl.: H01L 21/68

(54) **Elektrostatische Vorrichtung zum Halten von Wafern und anderen Bauteilen**

(71) Anmelder: VenTec Gesellschaft für Venturekapital und Unternehmensberatung, 57078 Siegen (DE)
(72) Erfinder: Busse, Karl-Herrmann Prof.Dr, 57234 Wilnsdorf (DE); Arlt,Joachim Dr, 53125 Bonn (DE)

(57) **Zusammenfassung**

Eine elektrostatische Haltevorrichtung, bei der vorzugsweise Polyimid als Dielektrikum dient und bei der die Plasmaresistenz durch Erzielung einer sehr planen Oberfläche erhöht wird, sowie eine elektrostatische Haltevorrichtung, bei der durch sorgfältige Vorbehandlung, Herstellung einer diffusionsdurchlässigen Elektrode und Modifikation des Klebers ein Einsatz bei Temperaturen bis 230°C möglich ist. Ferner kann durch eine partielle Modifikation des als Dielektrikum verwendeten Materials hinsichtlich der Dielektrizitätskonstante, die auf das Substrat (Wafer) ausgeübte Kraft (Haltekraft) eingestellt werden.

## Beschreibung

### Stand der Technik

Über elektrostatische Haltevorrichtungen, bei denen die Elektrode(n) (mit der Spannungsquelle verbundener Leiter) im wesentlichen durch ein organisches Polymer isoliert ist (sind), ist bereits viel gearbeitet worden.

In den Patenten wird zwar auch von anderen Polymeren gesprochen, aufgrund der vielen Vorteile (Plasmaresistenz, Partikelfreiheit, Temperaturstabilität, relativ hohe Dielektrizitätskonstante und hohe elektrische Durchschlagsfestigkeit) ist aber vor allem Polyimid gemeint. Es werden verschiedenste Systeme vorgeschlagen, die aber alle mit vielen Nachteilen behaftet sind. Insbesondere ist die Temperaturstabilität dieser Systeme schlecht.

Zwar sind einselne organische Polymere, insbesondere Polyimid, unter Vakuum und oder Schutzgasbedingungen bis über 400 Grad Celsius stabil, jedoch versagen die verwendeten Kleber zur Verbindung von Elektrode, Isolationsschichten und Grundkörper schon bei wesentlich niedrigeren Temperaturen, meistens im Bereich um 100 bis 150 Grad Celsius.

Der Stand der Technik ist insbesondere in den folgenden Patenten dargelegt:
Das US Patent 5.691.876 schlägt ein kleberloses elektrostatisches Haltesystem für Hochtemperaturanwendungen vor, das jedoch fertigungsmäßig extrem aufwendig ist.

Zu der dort vorgestellten Konzeption ist anzumerken, daß dieses elektrostatische Haltesystem zwar unter günstigen Bedingungen den vorgesehenen Temperaturen von 200°C bzw. 400°C widerstehen kann; bei der normalerweise vorhandenen Restfeuchte von Polyimidfolie (laut Datenblatt der Fa. DuPont bis ca. 4%) wird jedoch der beim Einsatz bei den vorgenannten Temperaturen entstehende Wasserdampf jede Verbindung zwischen flächiger metallischer Electrode, die als Diffusionssperre wirkt und Polyimid und oder dem Grundkörper (Pedestal) zerstören.

Das US Patent 5.708.557 schlägt vor, die Durchdruckfestigkeit der Isolationsschicht durch eine Füllung mit Fasern zu erhöhen.

Das EP 0.693.771 B1, entsprechend US 5.606.485 beschreibt eine Stufe zwischen 1 und 10 µm Höhe am Rand des Systems zur Verbesserung der Erosionsbeständigkeit im Plasma.

Das US Patent 5.634.266 beschreibt ein elektrostatisches Haltesystem, das durch eine Abstufung im Grundkörper eine erosionsfeste glatte Oberfläche erhält.

Das US Patent 5.625.526 beschreibt unter anderem ein System, in dem ein isolierender Polyimidfilm aus der Lösung erzeugt wird.

Das US Patent 5.560.780 und EP 0.635.869 A1 beschreibt ein System, in dem ein elektrostatisches Haltesystem aus Polyimidfolien durch eine Keramikshicht geschützt wird.

Das EP 0.260.150 A2 beschreibt ein elektrostatisches Haltesystem, bei dem die äußere Isolationsschicht der Elektrode aus Polyimid gefertigt ist.

In den folgenden Patenten ist zwar auch von elektrostatischen Haltesystemen die Rede, die zumindest teilweise aus Polyimid bestehen, jedoch ist bei dem eigentlichen Haltesystem, bestehend aus einem organischem Dielektrikum und einer metallischen Elektrode keine signifikante Verbesserung hinsichtlich der Temperaturstabilität und der Plasmaresistenz vorgenommen worden.

Das US Patent US 5.636.098 und EP 0.742.588 A2 beschreibt ein System, bei dem das elektrostatische Haltesystem durch eine Dichtung vom Plasma isoliert ist.

Das US Patent 5.486.975 beschreibt eine 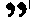 Schutzring", der das elektrostatische Haltesystem gegen das Plasma schützt.

Das EP 0.668.608 A1 beschreibt die Kontaktierung eines elektrostatischen Haltesystems.

Das EP 0.668.607 A1 beschreibt ein System, bei dem das elektrostatische Haltesystem durch zusätzliche Zuführung eines Schutzgases am Rand des Systems verbessert wird.

Das US Patent 5.528.451 beschreibt eine verbesserte Stromzuführung am Rande des Systems.

Das EP 0.805.487 A2 beschreibt ein elektrostatisches Haltesystem, in dem die Elektrode stark segmentiert ist. Bei Ausfall eines Segmentes wird dieses von der Spannungsversorgung abgetrennt und das System mit den übrigen Segmenten weiter betrieben.

Das EP 0.734.052 A1 beschreibt ein elektrostatisches Haltesystem, das sowohl in einer unipolaren als auch bipolaren Betriebsweise zu betreiben ist.

Das US Patent 5.671.117 enthält zusätzlich zum vorgenannten System noch eine Rückseitenkühlung über eine Vielzahl von ungleichäßig verteilten Gaszuführungsbohrungen.

Das US Patent 5.646.814 beschreibt ein elektrostatisches Haltesystem, in dem zwei Elektroden übereinander integriert sind, wobei die eine Elektrode verwendet wird, um das System auf den Grundkörper (Pedestal) zu fixieren, während das zweite System das Substrat fixiert.

Das US Patent 5.631.803 beschreibt ein elektrostatisches Haltesystem, bei dem auf die obere Folie, die die Isolationsschicht bildet, eine weitere aufgebracht ist, in die Furchen eingebracht sind, die als Kanäle zur Verteilung eines Wärmeübertragungsgases dienen.

Das US Patent 5.460.684 beschreibt ein elektrostatisches Haltesystem mit einer definierten Oberflächenrauheit, Polyimid ist ein mögliches Dielektrikum.

Das US Patent 5.592.358 beschreibt ein elektrostatisches Haltesystem, bei dem zur Erzielung eines gleichmäßigeren Plasmas auf der Oberfläche des Substrates ein Magnet im Grundkörper eingebaut ist.

Das US Patent 5.644.467 beschreibt ein elektrostatisches Haltesystem, das ein verstärktes Dielektrikum um die Kühlgaszuführungen beschreibt, um die Haltbarkeit des Systems zu erhöhen. Bei den auch beschriebenen gespritzten Keramikschichten, ist auch ausgeführt, wie dies zu realisieren ist, nicht jedoch bei dem ebenfalls als Dielektrikum erwähnten Polyimid.

Das US Patent 5.328.311 beschreibt ein elektrostatisches Haltesystem, bei dem ein mit flüssigem Stickstoff gekühlter und durch eine Heizung in der Temperatur geregelter Grundkörper verwendet wird. Das elektrostatische Haltesystem besteht aus Polyimid, Kupfer, Polyimid.

Das US Patent 5.275.683 beschreibt ein elektrostatisches Haltesystem, bei dem der Rad des Systems nach unten gebogen ist.

Das US Patent 5.191.506 beschreibt ein elektrostatisches Haltesystem, das unter anderem aus Polyimid, Kupfer, Polyimid besteht.

Das US Patent 5.255.153 beschreibt ein elektrostatisches Haltesystem, das unter anderem aus Polyimid, Kupfer, Polyimid besteht.

Das US Patent 4.645.218 beschreibt ein elektrostatisches Haltesystem, das unter anderem aus Polyimid, Kupfer, Polyimid besteht.

Das EP 0.467.390 A1 beschreibt ein elektrostatisches Haltesystem, bei dem ein flüssigkeitsgekühlter Grundkörper verwendet wird. Das elektrostatische Haltesystem ist Polyimid, Kupfer, Polyimid.

### Beschreibung der Erfindungen

Bei elektrostatischen Haltevorrichtungen mit organischem Dielektrikum (zum Beispiel Polyimid) existieren drei grundlegende Probleme, die die Lebensdauer sowie die Einsatzmöglichkeiten beschränken Diese sind:
**I.** Die beispielsweise gegenüber keramischen Systemen wesentlich niedrigere Standzeit in einer Plasmaumgebung, die auch zu Frühausfällen und damit zum Anlagenstillstand führt.
**II.** Die beispielsweise gegenüber keramischen Systemen wesentlich niedrigere Temperaturstabilität.
**III.** Die vielfach nicht ausreichende Homogenität der Temperaturverteilung eines Substrates auf dem elektrostatischen Haltesystem.

Ziel der Erfindung ist es daher bei einem elektrostatischen Haltesystem vorzugsweise auf der Basis von Polyimid Möglichkeiten zu schaffen, um die Temperaturstandfestigkeit und oder die Plasmaresistenz zu erhöhen sowie die Haltekraft pro Flächeneinheit variieren zu können und ein kostengünstiges System zu schaffen, das für Einsatzbedingungen in einer Anlage mit Oberflächentemperaturen des elektrostatischen Haltesystems bis 230°C und relativ drastischen Plasmabedingungen (zum Beispiel in 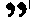 Narrow Gap" Ätzanlagen) verwendbar ist.

### I.

Bei drastischen Plasmabedingungen ist es von größter Wichtigkeit, daß das Plasma nicht auf das organische Dielektrikum einwirken kann.

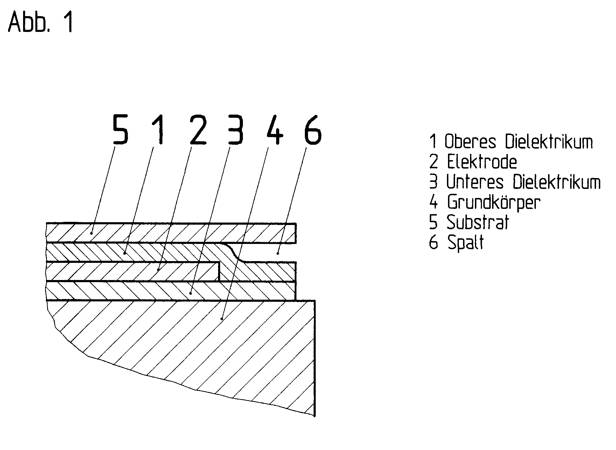

Theoretisch ist dies der Fall, da das Dielektrikum durch das Substrat (den Wafer) abgedeckt wird (Abbildung 1). Bei den Systemen nach dem Stand der Technik entsteht jedoch zwischen dem Substrat (5) und dem oberen Dielektrikum (1) zwangsläufig ein Spalt (6), in dem unter ungünstigen Bedingungen das Plasma zünden und das Dielektrikum (1) zerstören kann. Dieser Spalt ((6) in Abbildung 1) entsteht dadurch daß im Randbereich des Systems die Deckfolie (oberes Dielektrikum (1) in Abbildung 1) auch über die Elektrode (2) hinausgezogen werden muß, um diesen Randbereich zu isolieren.

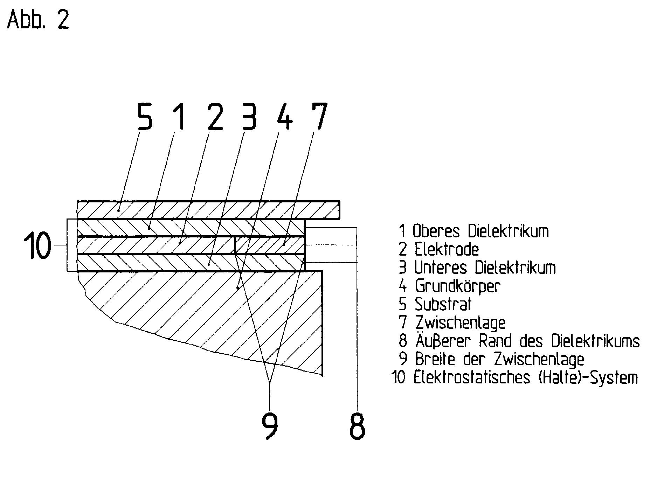

Gelingt es, diesen Spalt (6) zu vermeiden, so kann das Plasma nur am äußeren Rand des Dielektrikums angreifen. Bei einer normalen Dicke des oberen Dielektrikums (1) von 30 bis 150 µm und einer normalen Breite des Randes (gleich der Breite der Zwischenlage (9) Abbildung 2) zum Beispiel von 2000 bis 3000 µm muß ein vielfaches an Kunststoffmaterial zerstört werden, bis das Dielektrikum soweit zerstört ist, daß eine leitende Verbindung zwischen Plasma und Elektrode (2) entsteht.

In unserer Erfindung (siehe Abbildung 2) geschieht das dadurch, daß zwischen oberem Dielektrikum (1) und unterem Dielektrikum (3) eine Zwischenlage (7) eines organischen Isolators (zum Beispiel Polyimid mit oder ohne Kleber) eingefügt wird.

Diese Zwischenlage kann auch eingefügt werden, wenn im zentralen Bereich des elektrostatischen Haltesystems Kanäle notwendig sind, um ein Gas zur Verbesserung der Wärmeübertragung zwischen Grundkörper (4) und Substrat (5), zu verteilen.

Diese vorgenannten Überlegungen lassen sich in der Forderung nach einer möglichst guten Ebenheit der gesamten dem Substrat zugewandten Seite des elektrostatischen Haltesystems ((10) in Abbildung 2) zusammenfassen.

Entscheidend für die Plasmaresistenz ist dabei auch die Ebenheit am äußeren Rand des Dielektrikums (8) des elektrostatischen Systems ((10) in Abbildung 2).

Eine gute Ebenheit der gesamten dem Substrat zugewandten Oberfläche des elektrostatischen Haltesystems ((10) in Abbildung 2) bedingt eine gleichmäßig hohe Haltekraft und damit einen guten Kontakt zwischen dem elektrostatischen Haltesystem ((10) in Abbildung 2) und dem Substrat (5). Dadurch wird außerdem eine gleichmäßige Wärmeübertragung zwischen dem elektrostatischen Haltesystem ((10) in Abbildung 2) und dem Substrat (5) erreicht.

Ebenfalls wird durch eine gute Ebenheit der gesamten dem Substrat zugewandten Oberfläche des elektrostatischen Haltesystems ((10) in Abbildung 2) die Menge des am Rand des elektrostatischen Haltesystems abströmenden Wärmeübertragungsgases minimiert, falls ein solches verwendet wird.

### Herstellung eines Systems mit der geforderten Ebenheit

Basis ist eine Folie aus einem organischen Dielektrikum (in der Regel Polyimid, unteres Dielektrikum ((3) in Abbildung 2)), auf die mit oder ohne Kleber eine elektrisch leitende Elektrode (2) aus einem Metall, in der Regel Kupfer oder aus einem elektrisch leitenden oder leitfähig gemachten Polymer ( zum Beispiel durch Füllen mit einem feindispergierten Metall oder leitfähigen Kohlestoff) aufgebracht ist.

Die Länge und Breite der aus dem unteren Dielektrikum (3) und der leitenden Elektrode (2) hergestellten Grundfolie ist insgesamt deutlich größer als das spätere elektrostatische System ((10) in Abbildung 2). Im äußeren Bereich der so hergestellten Grundfolie werden im nächsten Schritt unverrückbare Paßmarken außerhalb der Abmessungen des letztendlichen elektrostatischen Systems ((10) in Abbildung 2) angebracht.

Durch Aussparen des oberen Dielektrikums (1), der Elektrode (2) und des unteren Dielektrikums (3) können auch Gaskanäle erzeugt werden. Soll der Randbereich dieser Gaskanäle (Bereich zwischen der Kante der Elektrode (2) und der Kante des oberen (1) und unterem Dielektrikums (3)) mit einer Zwischenlage (7) gemäß der Abbildung 2 ausgeführt werden, sind im später komplett ausgesparten Bereich des Gaskanals weitere Paßmarken anzubringen.

Im nächsten Schritt ist die leitfähige Seite der hergestellten Grundfolie (zukünftige Elektrode (2)) zum Beispiel durch nasses oder trockenes Ätzen zu strukturieren.

Für die Zwischenlage (7) wird eine weitere Folie aus einem Dielektrikum (vorzugsweise Polyimid) mit einer bis rund 10% größeren Dicke (inklusive Kleber) mit Paßmarken versehen. Diese müssen mit denen auf der Grundfolie hinsichtlich ihrer Lage übereinstimmen.

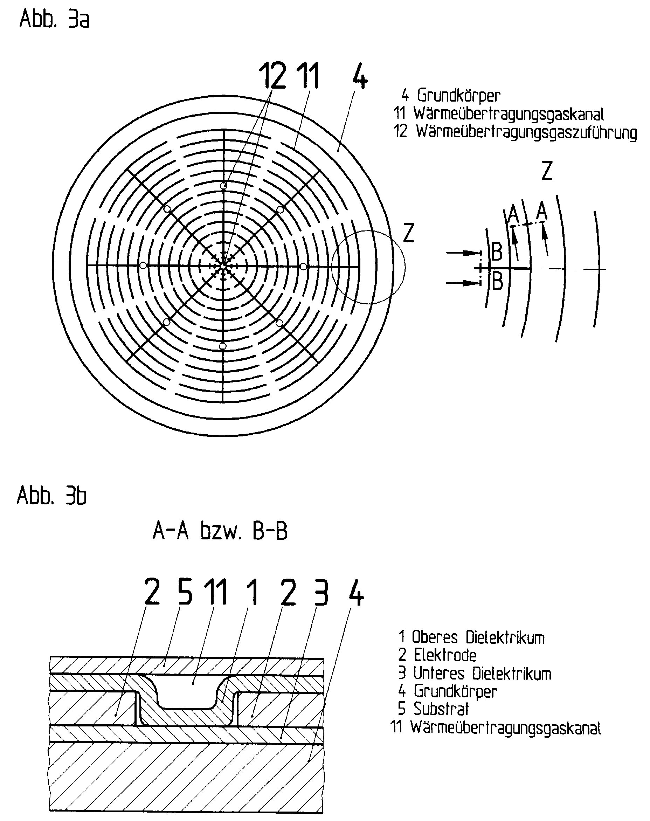

Die äußere Kontur (Außenkontur) der leitfähigen Seite der Grundfolie wird in diese Zwischenlage ((7) in Abbildung 2), zum Beispiel durch Stanzen, Fräsen oder Ätzen eingebracht. Die Zwischenlage (7) kann sowohl einen äußeren Ring (Zwischenring) und oder die Struktur der Elektrode abbilden, wie beispielsweise in Abbildung 3a dargestellt.

Entsprechend der erzeugten Paßmarken werden die Zwischenlage(n) (7) paßgenau auf die Grundfolie aufgelegt.

Auf dieses Foliensystem wird entsprechend den Eigenschaften der verwendeten Kleber in einer Presse uniaxial Druck von 10 bis 1000 kN und eine Temperatur von 50 bis 200 °C ausgeübt, um vorzuheften.

Auf dieses Foliensystem wird anschließend die Deckfolie (oberes Dielektrikum (1) in Abbildung 2) unter ähnlichen Verarbeitungsbedingungen geheftet.

Dann wird ein Kleber auf die Rückseite (die dem Grundkörper (4) zugewandte Seite des unteren Dielektrikum (3) in Abbildung 2) des durch mehrfaches Heften erzeugten Foliensystems aufgebracht.

Der äußere Rand des Dielektrikum ((8) in Abbildung 2) und wenn erforderlich auch die innere Struktur (Kanäle zur Verteilung eines Wärmeübertragungsgases) des elektrostatischen Haltesystem wird (werden) zum Beispiel durch Fräsen, Stanzen oder Ätzen erzeugt.

Dann wird das fertige elektrostatische Haltesystem ((10) in Abbildung 2) auf den Grundkörper (4) unter uniaxialem Druck von 10 bis 2000 kN in einer Presse bei einer Temperatur von 100 bis rund 350°C auf den Grundkörper aufgebracht. Dabei ist der Druck und oder die Verarbeitungstemperatur deutlich höher als bei den vorherigen Verklebungen anzusetzen.

Zur Erzielung einer sehr planen Oberfläche des elektrostatischen Systems ((10) in Abbildung 2) wird die Verpressung gegen eine plane, polierte und sehr harte Oberfläche (zum Beispiel geschliffener, gehärteter Stahl) durchgeführt.

### II.

Zur Erzielung einer hohen Temperaturstabilität des elektrostatischen Haltesystems ist die folgende Vorgehensweise notwendig. Polyimid enthält normalerweise bis zu 4% Feuchtigkeit. Thermisch aushärtende Kleber können Feuchtigkeit und Restlösemittel enthalten. Beim Aushärten des Klebers können unter Umständen weitere flüchtige Verbindungen entstehen. Diese flüchtigen Verbindungen führen, je höher die Temperatur ist desto eher zur Delamination der Klebeverbindung, wenn sie nicht aus dem System austreten können, weil einerseits der Dampfdruck der Verbindungen steigt und andererseits die Schälfestigkeit der Verklebungen mit steigender Temperatur stark abnimmt. Eine erste wesentliche Maßnahme um die Gefahr der Delamination herabzusetzen ist, Polyimidfolien und den Grundkörper nach jedem Fertigungschritt bei erhöhter Temperatur im Vakuum zu trocknen (zum Beispiel 0,5 bis 8 Stunden bei 60 bis 240°C und einem Druck von besser 10 hPa). Dies erhöht nach unseren Versuchen die Temperaturstandfestigkeit eines elektrostatischen Haltesystems auf Basis von Polyimid zum Beispiel bei Klebern auf Epoxidbasis um 30 bis 50°C. Wichtig ist vor allem der Trocknungsschritt direkt vor dem Aufpressen des elektrostatischen Haltesystems auf den Grundkörper, wenn massive flächige Metallelektroden verwendet werden, wie sie in elektrostatischen Haltevorrichtungen nach dem Stand der Technik enthalten sind. Diese wirken als äußerst effektive Diffusionssperren und erhöhen, da oftmals noch flüchtige Verbindungen in den Folien und oder dem Kleber enthalten sind, die Gefahr der Delamination erheblich.

Nach den Diffusionsgesetzen sinkt die aus einem System austretende Stoffmenge überproportional mit dem Weg. Wenn es also bei elektrostatischen Haltevorrichtungen, bei denen das untere Dielektrikum (3) aus Polyimid oder einem anderen flüchtige Bestandteile enthaltendem Dielektrikum gefertigt ist vielfach nicht möglich ist, einen Restgehalt an flüchtigen Inhaltsstoffen auszuschließen, muß diesen die Möglichkeit gegeben werden, auf möglichst kurzem Weg auszutreten.

Der kürzeste Weg ist jedoch der senkrecht zur Oberfläche des elektrostatischen Haltesystems ((10) in Abbildung 2). Dies bedingt eine Elektrode (2), die nicht als Diffusionssperre wirkt.

In diesem Teil der Erfindung verwenden wir daher diffusionsdurchlässige Elektroden ((2) in Abbildung 2) auf der Basis von eigenleitfähigen organischen Polymeren oder durch Zusatz eines feindispergierten Metalles oder leitfähigen Kohlenstoff leitfähig gemachte Polymere.

Die zweite mögliche Methode ist die, die Elektrode (2) durch schmale Zwischenräume (0.3 bis 8 mm breit) so stark zu segmentieren, daß die Diffusionswege kurz werden.

Diese Konstruktion hat nichts mit einer elektrostatischen Haltevorrichtung für nichtleitende Substrate zu tun (sog. I.D.E E-Chuck), bei dem die benachbarten Elektroden auf unterschiedlichen Potentialen liegen, während sie bei unserem System im wesentlichen auf dem gleichen Potential liegen.

Aufgrund der engen Zwischenräume ist es hier nicht wie bei der im Teil I dieser Erfindung beschriebenen Lösung möglich und auch nicht erwünscht, das obere Dielektrikum ((1) in Abbildung 2) in dem Bereich der Zwischenräume auszusparen.

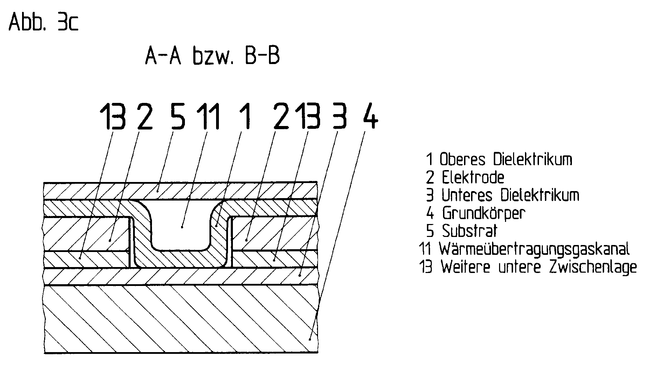

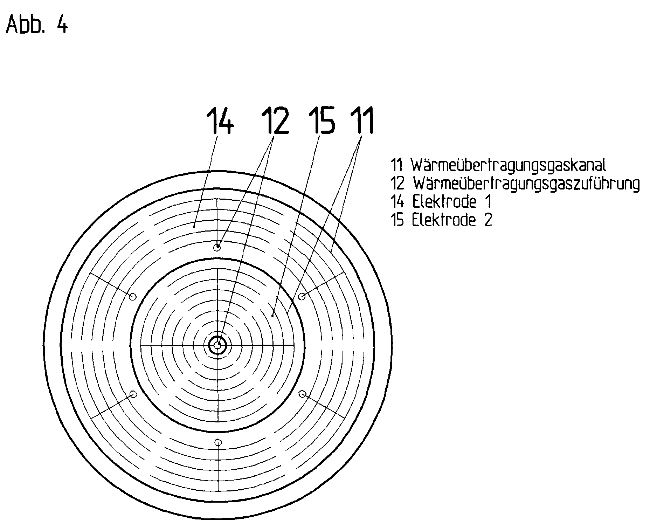

Die Abbildungen 3a, 3b und 3c zeigen eine der vielen möglichen Konfigurationen für ein unipolares und die Abbildung 4 eine solche für ein bipolares elektrostatisches Haltesystem.

Die Vielzahl dieser in die Elektrode ((2) in Abbildung 3a, 3b und 3c) eingearbeiteten Zwischenräume legen es nahe, sie auch zur Verteilung eines Gases zur Wärmeübertragung zu verwenden.

Dazu wird beim Aufpressen des Foliensystems auf den Grundkörper (4) eine Druckausgleichfolie verwendet, die dazu führt, daß in der Oberfläche der elastischen Deckfolie dort Vertiefungen entstehen, wo die Elektrode ((2) in Abbildung 2) beispielsweise durch das im Teil I dieser Schrift beschriebene Strukturieren der Elektroden ((2) in Abbildung 2) ausgespart ist. Diese Vertiefungen (Wärmeübertragungsgaskanal (11) in Abbildung 3a und 3b) sind etwas schmaler als die Aussparungen in der Elektrode (2) und können fast genau so tief sein, wie die Elektrode (2) dick ist.

Reicht der Querschnitt der Wärmeübertragungsgaskanäle ((11) in Abbildung 3b) zur Verteilung eines Wärmeübertragungsgases nicht aus, so kann die Elektrode (2) mit einer weiteren unteren Zwischenlage ((13) in Abbildung 3c), bevorsugt aus Polyimid, hinterlegt werden. Diese weitere untere Zwischenlage ((13) in Abbildung 3c) bildet im Bereich der Wärmeübertragungsgaskanäle (11) die rückseitige Geometrie der Elektrode (2) ab und setzt sich fort bis zum äußeren Rand des Dielektrikums ((8) in Abbildung 2). Die Tiefe der Wärmeübertragungsgaskanäle ((11) in Abbildung 3c) ist dann um die Dicke der weiteren unteren Zwischenlage ((13) in Abbildung 3c) vergrößert.

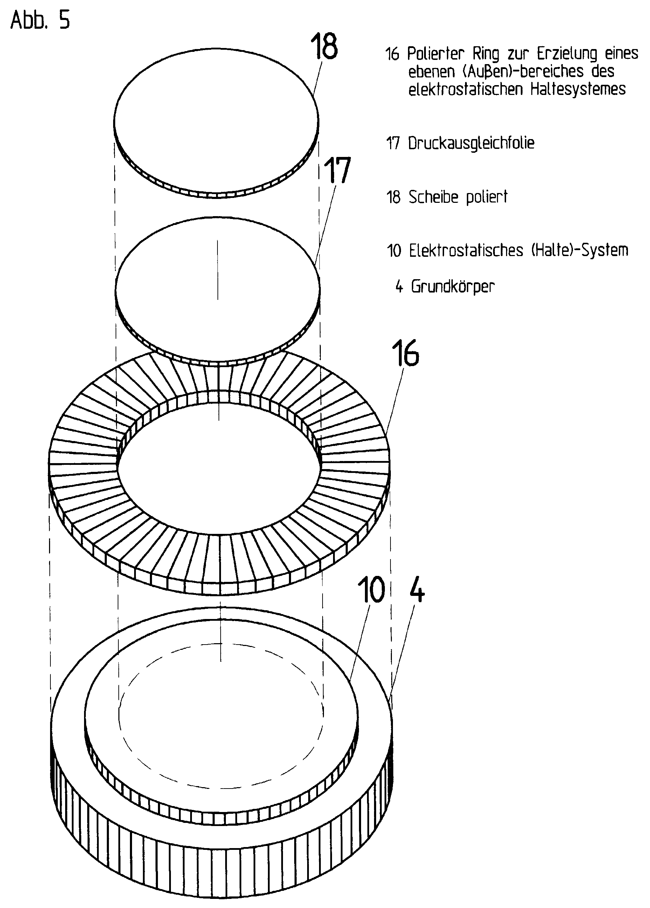

Die vorgenannte Ausführungsform eines elektrostatischen Haltesystems kann im Randbereich ohne Stufe ausgeführt werden, wie es im Teil I dieser Schrift und der Abbildung 2 beschrieben worden ist. Dazu wird beim Aufpressen ein Ring verwendet ((16) in Abbildung 5), der den äußeren Bereich des elektrostatischen Haltesystems abdeckt, (Breite ca. doppelt breit wie die Zwischenlage (7) in Abbildung 2). Der innere Bereich des Ringes und damit auch des elektrostatischen Haltesystems wird gegen eine Druckausgleichsfolie ((17) in Abbildung 5) verpreßt.

Diese muß mit einer harten, planen und polierten Scheibe zum Beispiel aus einem gehärteten Stahl ((18) in Abbildung 5) hinterlegt werden, damit die Dicke des Systems (bestehend aus Scheibe (18) plus Druckausgleichsfolie (17)) einige Prozent dicker ist, als der Ring (16), gegen den der Randbereich des elektrostatischen Haltesystems ((10) in Abbildung 5) verpreßt wird.

Diese bisher in Teil II genannten Vorgehensweisen erlauben es, die Delaminationsgefahr der eingesetzten Verklebungen erheblich zu reduzieren.

Ein thermisch reagierendes Epoxid kann jetzt bis zu einer Einsatztemperatur des elektrostatischen Haltesystems von 175°C verwendet werden, ohne das die Verklebungen versagen. Für höhere Einsatztemperaturen muß dieser Epoxidkleber modifiziert werden, dies kann wie unsere Arbeiten zeigen durch Zusatz einer Nitrilkomponente zu dem Kleber erreicht werden. Trotz der in der Regel niedrigeren Schälfestigkeit ist die Standfestigkeit eines so modifizierten Klebersystems unter den vorgenannten Bedingungen bis 230°C mehr als ausreichend.

### III.

Zur Erzielung einer besseren Homogenität der Temperaturverteilung eines Substrates (zum Beispiel eines Wafers) auf einem elektrostatischen Haltesystem durch eine geeignete Verteilung eines Wärmeübertragungsgases auf der Rückseite des Substrates ist es techisch und wirtschaftlich vorteilhaft, daß die Haltekraft einer elektrostatischen Haltevorrichtung nicht immer über die gesamte Fläche konstant ist. Die elektrostatische Haltekraft sollte in einzelnen Bereichen, zum Beispiel am Rand des Systems, pro Flächeneinheit größer sein und zwar ohne das dabei eine (oder mehrere) getrennte Teilelektrode(n) mit eigenen getrennten Spannungsversorgung(en) benötigt wird (werden). Hierdurch können Kostenvorteile erreicht werden, weil die Konstruktion und die Fertigung eines solchen elektrostatischen Haltesystems einfach ist und der Betrieb ohne Änderung der vorhandenen Spannungsversorgung vorgenommen werden kann. Diese Ausführung der Erfindung kann auch benutzt werden, um ein in einem Hochtemperaturprozeß verzogenes Substrat einzuebnen.

In vielen Schriften wird als ein Vorteil von elektrostatischen Haltevorrichtungen auf Keramikbasis angeführt, daß die Dielektrizitätskonstante einer Keramik weit höher ist als die von Kunststoffen ( 3,5 bei Polyimid und bis weit über 1000 bei Keramiken) und damit eine höhere Haltekraft (oder niedrigere Betriebsspannung) erreicht werden könnte. Dieser Vorteil ist aber in den meisten Fällen nicht praxisrelevant, weil bei theoretisch ähnlichen elektrischen Durchschlagsfestigkeiten reale Keramiken gegenüber organischen Folien mit wesentlich mehr Fehlern, zum Beispiel Poren, Mikrorisse, Einschlüsse, behaftet sind, die die Durchschlagsfestigkeit herabsetzen. Diese typischen Fehler von Keramiken machen es in der Praxis erforderlich die Keramiken für ein elektrostatisches Haltesystem, verglichen mit Folien aus organischen Polymeren (also auch Polyimid), sehr dick auszulegen. Demgegenüber sind fehlerfreie Keramiken zum gegenwärtigen Zeitpunkt nur mit einem sehr hohen wirtschaftlichen und technischen Aufwand zu fertigen und führen zu sehr hohen Kosten für ein derartiges elektrostatisches Haltesystem. Hingegen sind nahezu fehlerfreie Folien aus organischen Polymeren bis zu eine Stärke von weit unter 10 µm kostengünstig erhältlich. Suspendiert man jedoch in gelöstem thermoplastischen Polyimid ein Material mit einer hohen Dielektrizitätskonstante und stellt daraus Folien her, so kann man auch bei relativ niedrigen keramischen Füllstoffgehalten eine wesentliche Steigerung der Dielektrizitätskonstante erreichen. Geeignet sind als Füllstoffe zum Beispiel Titandioxid, Aluminiumoxid oder ein Alkali- oder Erdalkalititanat,das zur weiteren Erhöhung der Dielektrizitätskonstante auch mit seltenen Erden modifiziert sein kann. Das keramische Material sollte eine gleichmäßige, feine Körnung haben (erwünscht ist unter 1 µm).

Die oben beschriebene Vorgehensweise führt zu den nachfolgend aufgeführten Vorteilen: Bei gleicher Haltekraft einer elektrostatischen Haltevorrichtung kann so einerseits die Foliendicke erhöht und die Plasmaresistenz deutlich gesteigert werden. Eine vierfache Dielektrizitätskonstante erlaubt theoretisch die doppelte Foliendicke. Andererseits kann auch bei gleichbleibender Foliendicke bei einem relativ kleinen Substrat- und Grundkörperdurchmesser noch eine höhere Haltekraft im Vergleich zu einer ungefüllten Folie erreicht werden.

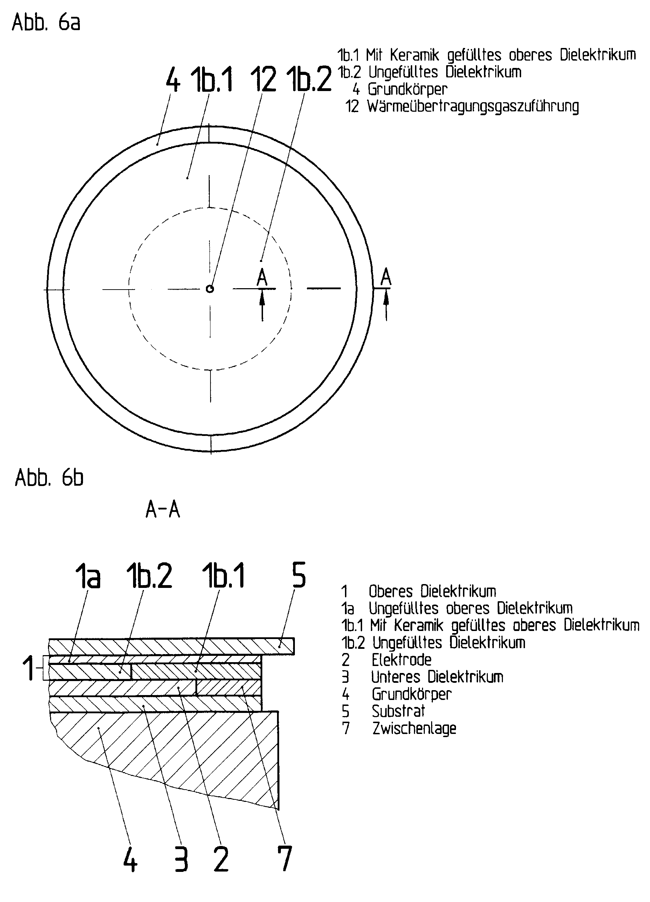

Eine weitere Anwendung ist ein geteiltes oberes Dielektrikum (zum Beispiel gemäß Abbildung 6a). Da die Haltekraft eines elektrostatischen Haltesystems bei gegebener Dicke des oberen Dielektrikums ((1) in Abbildung 2) und ungelegter Spannung linear von der Dielektrizitätskonstante abhängt, kann in Bereichen in denen eine verstärkte Haltekraft erforderlich ist (beispielsweise am Rand des elektrostatischen Haltesystems) eine mit Keramik gefüllte Folie verwendet werden.

Zur Erzielung einer planen Oberfläche schlagen wir die folgende Vorgehensweise vor: Auf eine dünne Folie (vorzugsweise Polyimid; (1a) in Abbildung 6b), die später die Oberfläche des dem Substrat zugewandten elektrostatischen Haltesystems bilden wird, (Dicke der Folie (1a) typischerweise 1/3 bis ¼ der gesamten Dicke des oberen Dielektrikums (1) in Abbildung 6b) werden die gefüllten ((1b.1) in Abbildung 6a und 6b) und nichtgefüllten Folienstücke (1b.2) in Abbildung 6a und 6b (Dicke der Folien (1b.2) beziehungsweise' (1b.1) 2/3 bis ¾ des gesamten oberen Dielektrikums) paßgenau aufgeklebt. Das so vorbereitete obere Dielektrikum (1) (bestehend nun aus den Folien (1a), (1b.1) und (1b.2) in Abbildung 6b) wird auf die Elektrode ((2) in Abbildung 6b) aufgebracht und dann das gesamte elektrostatische Haltesystem ((10) in Abbildung 2) je nach Anforderung entweder gegen eine plane, harte, polierte Platte oder eine Druckausgleichsfolie verpreßt.

Es ist auch möglich, die gefüllte Folie ((1b.1)) in Abbildung 6a und 6b) durch eine Keramik oder keramische Beschichtung der Folie ((1a) in Abbildung 6b) zu ersetzen.

### Beschreibung der Zeichnungen

Die Abbildung 1 beschreibt einen Schnitt durch den Randbereich einer elektrostatischen Haltevorrichtung mit Substrat (Wafer) nach dem gegenwärtigen Stand der Technik; dabei ist (1) das obere Dielektrikum, (2) die Elektrode, (3) das untere Dielektrikum, (4) der Grundkörper, (5) das Substrat und (6) der durch das Aufpressen des oberen Dielektrikums auf das System entstehende Spalt, in dem ein Plasma angreifen bzw. durchschlagen kann.

Die Abbildung 2 beschreibt einen Schnitt durch den Randbereich einer elektrostatischen Haltevorrichtung nach dem ersten Teil dieser Erfindung, dabei ist (1) das obere Dielektrikum, (2) die Elektrode, (3) das untere Dielektrikum, (4) der Grundkörper, (5) das Substrat, (7) die Zwischenlage zum Ausgleichen der Höhe der Elektrode, (8) der äußere Rand des Dielektrikums, an dem das Plasma nach dieser Erfindung nur noch angreifen kann, (9) die Breite der Zwischenlage, das heißt die Breite des Materials das bei dieser Erfindung abgetragen werden muß, bevor das Plasma zur Elektrode durchschlägt und (10) das gesamte elektrostatische (Halte-)System.

Die Abbildung 3a beschreibt eine Draufsicht mit der Einzelheit Z auf eine elektrostatische Haltevorrichtung nach dem zweiten Teil dieser Erfindung in einer unipolaren Ausführung. Dabei ist (4) der Grundkörper, (11) der Kanal für das Wärmeübertragungsgas und (12) gibt die Lage der Zuführung(en) für das Wärmeübertragungsgas an.

Die Abbildung 3b beschreibt einen Schnitt A-A bzw. B-B in der Einzelheit Z der Abbildung 3a. Dabei ist (1) das obere Dielektrikum, (2) die Elektrode, (3) das untere Dielektrikum, (4) der Grundkörper, (5) das Substrat und (11) ist der Kanal für das Wärmeübertragungsgas.

Die Abbildung 3c beschreibt einen Schnitt A-A bzw. B-B in der Einzelheit Z der Abbildung 3a bei Verwendung einer weiteren unteren Zwischenlage (13). Dabei ist (1) das obere Dielektrikum, (2) die Elektrode, (3) das untere Dieletrikum, (4) der Grundkörper, (5) das Substrat, (11) der Kanal für das Wärmeübertragungsgas und (13) die weitere untere Zwischenlage zur Vergrößerung der Tiefe des Wärmeübertragungsgaskanals (11).

Die Abbildung 4 beschreibt eine elektrostatische Haltevorrichtung nach dem zweiten Teil dieser Erfindung, in einer bipolaren Ausführung, dabei ist (11) ein Wärmeübertragungsgaskanal und (12) gibt die Lage der Zuführung(en) für das Wärmeübertragungsgas an, (14) ist die erste und (15) ist die zweite Elektrode des elektrostatischen Haltesystems.

Die Abbildung 5 beschreibt eine Vorrichtung zum Aufpressen eines elektrostatischen Haltesystems ohne Stufe im Randbereich kombiniert mit einer strukturierten Elektrode. Dabei ist (4) der Grundkörper, (10) das elektrostatische Haltesystem, (16) der ebene polierte Ring, (17) die Druckausgleichsfolie und (18) die polierte Scheibe.

Die Abbildung 6a zeigt einen Vorschlag gemaß Teil III der Erfindung für ein elektrostatisches Haltesystem bei dem das obere Dielektrikum aus Folien mit unterschiedlicher Dielektrizitätskonstante besteht. Dabei ist die Folie (1b.1) mit einer feindispergierten Keramik gefüllt und die Folie (1b.2) ungefüllt. (4) ist der Grundkörper und (12) die Zuführung für das Wärmeübertragungsgas.

Die Abbildung 6b beschreibt den Schnitt A-A in der Abbildung 6a durch den Randbereich einer elektrostatischen Haltevorrichtung. Dabei ist (1a) die ungefüllte Deckfolie des oberen Dielektrikum (1) und (1b.1) die gefüllte zweite Schicht des oberen Dielektrikums (1), (1b.2) die ungefüllte zweite Schicht des oberen Dielektrikums, (2) die Elektrode, (3) das untere Dielektrikum, (4) der Grundkörper, (5) das Substrat und (7) die Zwischenlage zum Ausgleichen der Höhe der Elektrode.

## Patentansprüche

1. Eine elektrostatische Haltevorrichtung (Haltesystem), die ein elektrisch leitendes Werkstück spannt, bestehend aus einer Elektrode die zwischen zwei isolierende Schichten aus einem organischem Material, bevorzugt Polyimid, eingearbeitet ist und die auf einem metallischen oder nichtmetallischen Grundkörper mit oder ohne Beschichtung aufgebracht ist.

2. Eine elektrostatische Haltevorrichtung nach Anspruch 1, bei der durch Einlegen einer isolierenden Zwischenlage, zum Beispiel in Form eines Zwischenringes, welche die Dicke der Elektrode hat oder bis zu 10% dicker ist, ein Spalt am Rand des elektrostatischen Haltesystems beziehungsweise Foliensystems ausgeschlossen wird.

3. Eine elektrostatische Haltevorrichtung nach Anspruch 1 und 2, bei der durch Verpressen gegen eine plane, harte und polierte Platte eine höchstmögliche Eberheit der Oberfläche erreicht wird.

4. Eine Elektrode nach Anspruch 1, dadurch gekennzeichnet, daß diese in einem regelmäßigen und oder unregelmäßigen Abstand, normalerweise 1 bis 15 mm, von regelmäßigen und oder unregelmäßigen Spalten von 0.3 bis 8 mm Breite (typischerweise 0,5 bis 1 mm) unterbrochen ist.

5. Eine Elektrode nach einem oder mehreren der Ansprüche 1 bis 4, die dadurch gekennzeichnet ist, daß die durch die Spalten gebildeten Teilflächen auf dem gleichen Potential liegen und innerhalb oder außerhalb der Elektrode leitend verbunden sind.

6. Eine Elektrode nach einem oder mehreren der Ansprüche 1 bis 5, wobei die Elektrode aus einem eigenleitfähigen Polymer besteht.

7. Eine Elektrode nach einem oder mehreren der Ansprüche 1 bis 5, wobei die Elektrode aus einem durch eine Füllung mit einem feindispergierten Metall oder leitfähigen Kohlenstoff leitfähig gemachten organischen Material besteht.

8. Eine Elektrode nach einem oder mehreren der Ansprüche 1 bis 7, die dadurch gekennzeichnet ist, daß die Dicke der Elektrode 5 bis 500 µm, typischer Weise 10 bis 70 µm beträgt.

9. Ein elektrostatisches Haltesystem nach einem oder mehreren der Ansprüche 1 bis 8, dadurch gekennzeichnet, daß das obere Dielektrikum über die gesamte Fläche des elektrostatischen Haltesystems, bis auf die Stellen, an denen das Wärmeübertragungsgas zugeführt wird und falls erforderlich für die Vorrichtung zum Anheben des Substrates, nicht unterbrochen ist.

10. Ein elektrostatisches Haltesystem nach einem oder mehreren der Ansprüche 1 bis 8, dadurch gekennzeichnet, daß das untere Dielektrikum über die gesamte Fläche des elektrostatischen Haltesystems, bis auf die Stellen, an denen das Wärmeübertragungsgas zugeführt wird und die elektrische Kontaktierung hergestellt wird und falls erforderlich für die Vorrichtung zum Anheben des Substrates, nicht unterbrochen ist.

11. Ein elektrostatisches Haltesystem nach einem oder mehreren der Ansprüche 1 bis 10, bei dem die elektrostatische Haltevorrichtung unipolar ausgelegt ist.

12. Ein elektrostatisches Haltesystem nach einem oder mehreren der Ansprüche 1 bis 10, bei dem die elektrostatische Haltevorrichtung bipolar ausgelegt ist.

13. Ein elektrostatisches Haltesystem nach einem oder mehreren der Ansprüche 1 bis 12, bei denen eine oder mehrere Folienlagen des oberen und oder unteren Dielektrikums zur Erhöhung der Dielektrizitätskonstante mit einem Material mit höherer Dielektrizitätskonstante als das organische Folienmaterial gefüllt ist (sind), zum Beispiel Titandioxid, Aluminiumoxid, Alkali- oder Erdalkalitanate auch mit seltenen Erden modifiziert.

14. Ein elektrostatisches Haltesystem nach Anspruch 13, wobei der Rohstoff für die gefüllte Folie durch Mischen eines gelösten thermoplastischen Polyimides oder eines anderen löslichen organischen Polymers mit dem keramischen Füllstoff hergestellt wird und durch Gießen oder Streichen zu einer Folie verarbeitet wird.

15. Ein elektrostatisches Haltesystem nach einem oder mehreren der Ansprüche 1 bis 14, bei dem die obere dem Substrat zugewandte Isolationsfolie so zweischichtig oder mehrlagig ausgeführt wird, daß die obere typischerweise dünnere Isolationsfolie bis auf die in Anspruch 9 genannten möglichen Unterbrechungen aus einem Stück besteht und die untere oder mehrere der unteren Isolationsfolien aus mehreren Teilstücken mit unterschiedlich hohen Dielektrizitätskonstanten zusammengesetzt ist (sind).

16. Ein elektrostatisches Haltesystem nach Anspruch 15, bei dem die Folien, die zur Erhöhung der Dielektrizitätskonstante gefüllt sind, durch Keramik oder keramische Beschichtungen ersetzt sind.

17. Ein elektrostatisches Haltesystem nach einem oder mehreren der Ansprüche 1 bis 16, bei dem für alle notwendigen Verklebungen von Grundkörper, unterer Isolierung, Elektrode, oberer Isolierung und Zwischenlage(n) ein nitrilmodifizierter thermisch reagierender Epoxidkleber verwendet wird und das ganze elektrostatische Haltesystem so bei Temperaturen bis 230 Grad Celsius stabil ist.

18. Ein elektrostatisches System nach einem oder mehreren der Ansprüche 1 bis 17, das vor oder nach dem Aufbringen der einzelnen Bestandteile, wie Folien, Elektrode und dessen Grundkörper, bei Temperaturen von 60 bis 240°C unter Vakuum getrocknet wird.

19. Ein elektrostatisches Haltesystem nach einem oder mehreren der Ansprüche 1 bis 18, das in einer Presse bei Temperaturen zwischen 100 und 350 Grad Celsius und Drücke von 10 bis 2000 kN unter Verwendung einer bei dieser Temperatur plastischen Hilfsfolie (Druckausgleichsfolie) aufgebracht wird, so daß sich nach dem Verpressen die Spalte in der Elektrode nach Anspruch 4 in der dem Substrat zugewandten Oberfläche des Systems abzeichnen.

20. Ein elektrostatisches Haltesystem nach einem oder mehreren der Ansprüche 1 bis 19, bei dem die Spalte und Vertiefungen nach Anspruch 19 zur Verteilung eines Gases zwischen dem Substrat und dem elektrostatischen Haltesystem benutzt werden.

21. Ein elektrostatisches Haltesystem nach einem oder mehreren der Ansprüche 1 bis 20, bei dem die Spalte und Vertiefungen nach Anspruch 19 hinsichtlich ihrer Tiefe dadurch vergrößert werden, daß die Elektrode mit einer weiteren Folienlage hinterlegt wird.
